# EUROPEAN PATENT APPLICATION

(11) **EP 1 380 858 A1**
(43) Date of publication of application: **14.01.2004**
(21) Application number: 02254813.5
(22) Date of filing: 09.07.2002
(51) Int. Cl.: G02B 1/11

(54) **Method for manufacturing an anti-reflective coating on a substrate for the production of a polarizer**

(71) Applicant: Cosmos Vacuum Technology Corporation, Taipei County (TW)
(72) Inventor: Chou, Chung-Lin, Taipei City (TW)
(74) Representative: Vleck, Jan Montagu

(57) **Abstract**

A method for making an anti-reflection coating on a plastic substrate (2) for the production of a polarizer includes the steps of (a) placing the plastic substrate (2) and a target (8) in a vacuum chamber (3) in such a manner that the substrate (2) and the target (8) are spaced apart from each other by a distance (L) greater than 60 centimeters, (b) maintaining the chamber (3) at a temperature less than 60°C, (c) applying an electron beam to the target (8) so as to form a vapor, which is subsequently deposited on the substrate (2) to form a film (41) thereon, and (d) simultaneously bombarding the substrate (2) and the vapor with an ion beam (9) during the formation of the film (41).

## Description

This invention relates to a method for making an anti-reflection coating on a substrate, more particularly to a method for making an anti-reflection coating on a substrate for the production of a polarizer with the use of an ion-beam-assisted deposition technique.

Polarizers are used in the production of liquid crystal display (LCD) devices, and are normally prepared by a method that involves deposition of an anti-reflection coating on a plastic substrate that includes a polyvinyl alcohol layer, two TAC (triacetyl cellulose) layers formed on two opposite surfaces of the polyvinyl alcohol layer, a protecting layer formed on one of the triacetate cellulose layers, an adhesive layer formed on the other one of the triacetate cellulose layers, and a release film attached to the other one of the triacetate cellulose layers via the adhesive layer and releasable therefrom. The aforesaid deposition can be carried out by physical vapor deposition techniques, such as electron beam vapor deposition, magnetron sputtering, and ion beam deposition. The electron beam vapor deposition technique involves the use of an electron beam to hit a surface of a target of a deposition material in a vacuum chamber, which, in turn, results in heating of the target and formation of vapor of the deposition material that is subsequently deposited on the substrate in the vacuum chamber. Heat is generated in the chamber by virtue of impact of the electron beam onto the target, and is removed by a cooling device installed in the chamber. Since the substrate is arranged at a position close to the target in the vacuum chamber for facilitating deposition of the vapor onto the substrate and since the amount of heat generated during the deposition is relatively large, the adhesive layer tends to decompose and the substrate may be damaged by virtue of the heat transferred from the target and the vapor to the substrate.
Therefore, the object of the preferred embodiment of the present invention is to provide a method for making an anti-reflection coating on a plastic substrate for the production of a polarizer that is capable of overcoming the aforementioned drawbacks of the prior art.

According to the present invention, a method for making an anti-reflection coating on a plastic substrate for the production of a polarizer comprises the steps of: (a) placing the plastic substrate and a target of a deposition material in a vacuum chamber in such a manner that the substrate and the target are spaced apart from each other by a distance greater than 60 centimeters; (b) maintaining the chamber at a temperature less than 60 °C ; (c) applying an electron beam to the target to heat the target so as to form a vapor of the deposition material, which is subsequently deposited on the substrate to form a film on the substrate; and (d) simultaneously bombarding the substrate, the vapor, and the film with an ion beam during the formation of the vapor.

In the drawings which illustrate an embodiment of the invention,

Fig. 1 is a flow diagram illustrating consecutive steps of a method embodying this invention for making an anti-reflection coating on a substrate for the production of a polarizer;

Figs. 2 and 3 are schematic sectional views to illustrate how the anti-reflection coating is formed on the substrate in a vacuum chamber according to the method of this invention; and

Fig. 4 is a fragmentary sectional view of the substrate used according to the method of this invention.

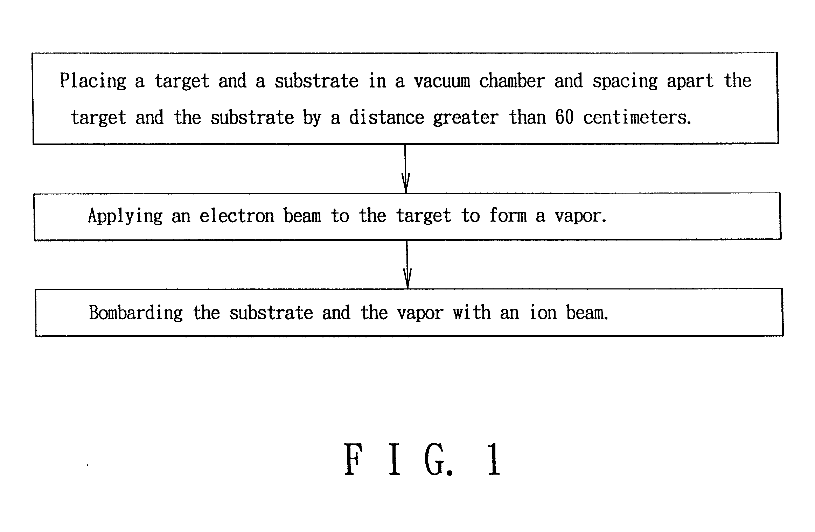

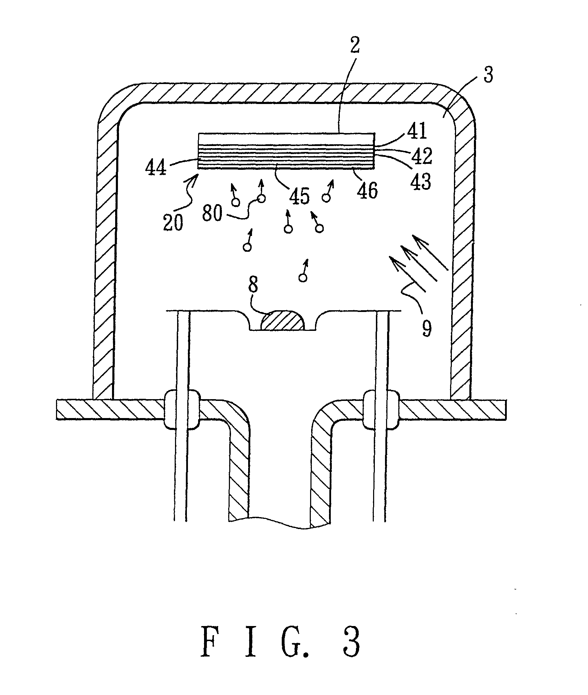

Fig. 1 shows consecutive steps of a method embodying this invention for making an- anti-reflection coating 20 (see Fig. 3) on a plastic substrate 2 for the production of a polarizer.

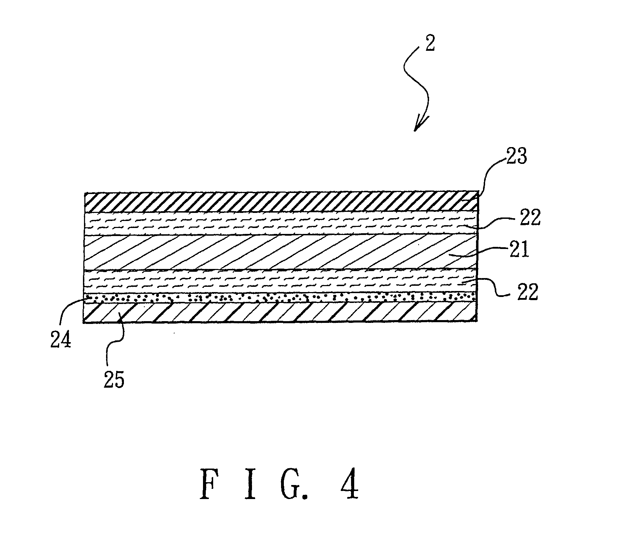

Referring to Fig. 4, the substrate 2 includes a polyvinyl alcohol layer 21, two triacetate cellulose layers 22 formed on two opposite surfaces of the polyvinyl alcohol layer 21, a protecting layer 23 formed on one of the triacetate cellulose layers 22, an adhesive layer 24 formed on the other one of the triacetate cellulose layers 22, and a release film 25 attached to the other one of the triacetate cellulose layers 22 via the adhesive layer 24 and releasable therefrom. The polarizer made from these material deteriorates at a temperature of above 60 °C .

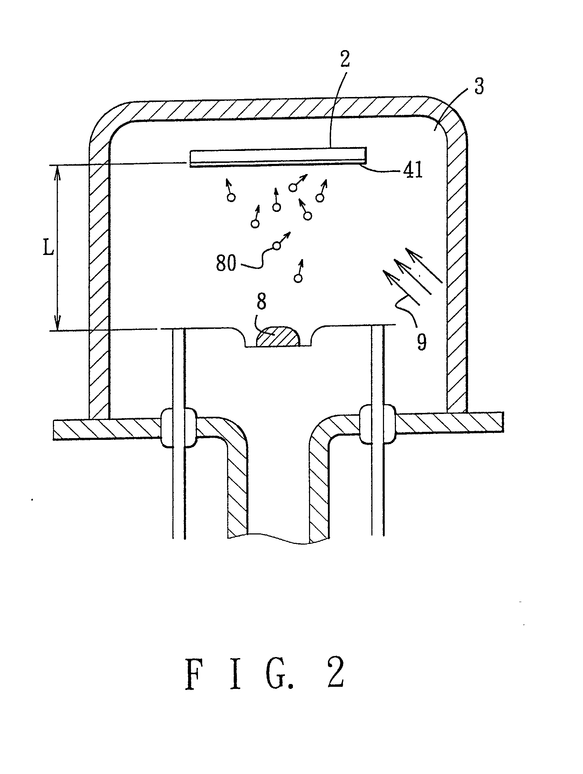

Referring now to Figs. 2 and 3, in combination with Fig. 1, the method includes the steps of: (a) placing the plastic substrate 2 and a target 8 of a first deposition material in a vacuum chamber 3 in an electron beam vapor deposition apparatus in such a manner that the substrate 2 and the target 8 are spaced apart from each other by a distance (L) greater than 60 centimeters, the pressure in the vacuum chamber 3 being kept at about 2 X 10⁻³ newton/m²; (b) maintaining the chamber 3 at a temperature less than 60°C; (c) applying an electron beam to the target 8 to heat the target 8 so as to form a vapor 80 of the first deposition material, which is subsequently deposited on the substrate 2 to form a first film 41 on the substrate 2; (d) simultaneously bombarding the substrate 2, the vapor 80, and the film 41 with an ion beam 9 during the formation of the vapor 80; (e) replacing the first deposition material with a second deposition material for the target 8 and repeating steps (b) to (d) to form a second film 42 on the first film 41; and (f) repeating step (e) to form third, fourth, fifth, and sixth films 43, 44, 45, 46, which are made from third, fourth, fifth, and sixth deposition materials in series on the substrate 2. The first, second, third, fourth, fifth, and sixth films 4 cooperately form the anti-reflection coating 20. Note that the vacuum chamber 3 and the substrate 2 are cleaned with a plasma of oxygen, nitrogen, or argon prior to the supply of the electron beam.

The first deposition material has a reflectivity higher than 2.0, and is a metal oxide compound selected from a group consisting of Ta₂O₅, Cr₂O₃, TiO₂, ZnS, ZnO₂, CdTe, CdS, and Nd₂O₃. The second deposition material has a reflectivity less than 1.5, and is an inorganic compound selected from a group consisting of BaF₂, MgF₂, Na₃AlF₆, Na₅Al₃F₁₄, YbF₃, CeF₃, and SiO₂. The third, fourth, and fifth deposition materials are selected from the same group as the second deposition material. The sixth deposition material is an inorganic compound selected from a group consisting of BaF₂, MgF₂, and SiO₂.

Preferably, the first film 41 has a thickness ranging from 10 to 15 nanometers, the second film 42 has a thickness ranging from 20 to 40 nanometers, the third film 43 has a thickness ranging from 65 to 85 nanometers, the fourth film 44 has a thickness of about 137.5 nanometers, the fifth film 45 has a thickness ranging from 20 to 40 nanometers, and the sixth film 46 has a thickness of about 100 nanometers.

The thus formed anti-reflection coating 20 permits the polarizer of this invention to possess a low surface reflectivity of less than 0.2%.

Note that the distance between the target 8 and the substrate 2 is greatly increased in order to minimize the amount of heat transferred from the vapor 80 and the target 8 to the substrate 2. Thus, the adhesive layer 24 can be protected from decomposing and the substrate 2 can be protected from damage. As a consequence, momentum of the vapor 80 to the substrate 2 is weakened, which can adversely affect deposition of the vapor 80 on the substrate 2 . However, with the inclusion of the ion beam 9 in the vacuum chamber 3 according to the method of this invention, momentum of the vapor 80 can be greatly enhanced via the ion beam 9 without a big increase in the temperature of the substrate 2. Moreover, the use of the ion beam 9 enables deposition of the vapor 80 to be carried out at a lower temperature, such as at room temperature, and permits formation of uniform and fine grain size of the first, second, third, fourth, fifth, and sixth films 41, 42, 43, 44, 45, 56 of the anti-reflection coating 20 on the substrate 2.

## Claims

1. A method for making an anti-reflection coating on a plastic substrate (2) for the production of a polarizer, the method **characterized by** the steps of:
(a) placing the plastic substrate (2) and a target (8) of a deposition material in a vacuum chamber (3) in such a manner that the substrate (2) and the target (8) are spaced apart from each other by a distance (L) greater than 60 centimeters;
(b) maintaining the chamber (3) at a temperature less than 60°C ;
(c) applying an electron beam to the target (8) to heat the target (8) so as to form a vapor of the deposition material, which is subsequently deposited on the substrate (2) to form a film (41) on the substrate (2); and
(d) simultaneously bombarding the substrate (2) , the vapor, and the film (41) with an ion beam (9) during the formation of the vapor.

2. A method for making an anti-reflection coating, **characterized by** the steps of:
(a) preparing a plastic substrate (2) including a polyvinyl alcohol layer (21), two triacetate cellulose layers (22) formed on two opposite surfaces of the polyvinyl alcohol layer (21), a protecting layer (23) formed on one of the triacetate cellulose layers (22), an adhesive layer (24) formed on the other one of the triacetate cellulose layers (22), and a release film (25) attached to the other one of the triacetate cellulose layers (22) via the adhesive layer (24) and releasable therefrom;
(b) placing the plastic substrate (2) and a target (8) of a deposition material in a vacuum chamber (3) in such a manner that the substrate (2) and the target (8) are spaced apart from each other by a distance (L) greater than 60 centimetres;
(c) maintaining the chamber (3) at a temperature less than 60°C;
(d) applying an electron beam to the target (8) to heat the target (8) so as to form a vapor (80) of the deposition material, which is subsequently deposited on the substrate (2) to form a film (41) on the substrate (2); and
(e) simultaneously bombarding the substrate (2), the vapor (80), and the film (41) with an ion beam (9) during the formation of the vapor (80).

3. A method for making an anti-reflection coating, according to Claim 1, including the steps of:
(a) preparing a plastic substrate (2) including a polyvinyl alcohol layer (21), two triacetate cellulose layers (22) formed on two two opposite surfaces of the polyvinyl alcohol layer (21), a protecting layer (23) formed on one of the triacetate cellulose layers (22), an adhesive layer (24) formed on the other one of the triacetate cellulose layers (22), and a release film (25) attached to the other one of the triacetate cellulose layers (22) via the adhesive layer (24) and releasable therefrom;
(b) placing the plastic substrate (2) and a target (8) of a deposition material in a vacuum chamber (3) in such a manner that the substrate (2) and the target (8) are spaced apart from each other by a distance (L) greater than 60 centimetres;
(c) maintaining the chamber (3) at a temperature less than 60°C;
(d) applying an electron beam to the target (8) to heat the target (8) so as to form a vapor (80) of the deposition material, which is subsequently deposited on the substrate (2) to form a film (41) on the substrate (2); and
(e) simultaneously bombarding the substrate (2), the vapor (80), and the film (41) with an ion beam (9) during the formation of the vapor (80).
